# EUROPÄISCHE PATENTSCHRIFT

(11) **EP 3 114 094 B1**
(45) Veröffentlichungstag und Bekanntmachung des Hinweises auf die Patenterteilung: **18.05.2022**
(21) Anmeldenummer: 15700249.4
(22) Anmeldetag: 14.01.2015
(51) Int. Cl.: B23K 103/00, C03B 33/07, C03B 33/09

(54) **VERFAHREN UND VORRICHTUNG ZUM SCHNEIDEN EINER LAMINIERTEN, ULTRADÜNNEN GLASSCHICHT**
APPARATUS AND METHOD OF CUTTING A LAMINATED, ULTRA-THIN GLASS LAYER
DISPOSITIF ET PROCÉDÉ DE DÉCOUPER UNE COUCHE DE VERRE LAMINÉE ULTRAMINCE

(30) Priorität: 04.03.2014 EP 14157625
(43) Veröffentlichungstag der Anmeldung: 11.01.2017
(73) Patentinhaber: SAINT-GOBAIN GLASS FRANCE, 92400 Courbevoie (FR)
(72) Erfinder: YEH, Li-Ya, 52511 Geilenkirchen (DE)
(74) Vertreter: Gebauer, Dieter Edmund
(86) Internationale Anmeldenummer: PCT/EP2015/050540
(87) Internationale Veröffentlichungsnummer: WO 2015/132008

(56) Entgegenhaltungen:
- WO-A1-2014/010686
- WO-A1-2014/030521
- DE-T2- 69 524 613
- DE-U1-202007 001 346
- JP-A- 2001 212 683
- JP-A- 2004 182 530
- US-A- 5 622 540
- US-A1- 2008 236 199
- US-A1- 2008 290 077
- US-A1- 2011 049 765
- US-A1- 2012 024 928
- US-A1- 2014 054 348
- US-B1- 6 407 360
- US-B1- 6 744 009

## Beschreibung

Die Erfindung betrifft ein Verfahren zum Schneiden einer laminierten, ultradünnen Glasschicht, sowie eine dazu geeignete Vorrichtung.

Unter ultradünnen Glasschichten werden typischerweise Glasschichten von einer Dicke bis zu etwa 0,3 mm verstanden. Sie zeichnen sich neben einem geringen Gewicht insbesondere durch ihre hohe, folienartige Flexibilität aus. Ultradünne Glasschichten werden folglich insbesondere in flexiblen Bauteilen eingesetzt, beispielsweise in flexiblen Dünnschichtsolarzellen, OLED-Elementen oder für folienartige aktive Verglasungselemente mit elektrisch schaltbaren Eigenschaften. Ultradünne Glasscheiben können aufgerollt werden, wodurch sie gut zu lagern und transportieren sind. Sie erlauben ferner die industrielle Bearbeitung in sogenannten "Roll-to-roll"-Prozessen. Beispielhaft sei hierzu auf die EP 2 463 249 A1 verweisen.

Das Zuschneiden ultradünner Glasschichten stellt eine Herausforderung dar. Klassische mechanische Glasschneide-Methoden sind nicht geeignet, da sie zu einer seiner rauhen Schnittkante mit Mikrorissen und anderen Beschädigungen führen. Eine nachträgliche Kantenbearbeitung, wie bei dickeren Glasscheiben üblich, ist aufgrund der geringen Dicke nicht möglich. Laserschnittverfahren führen zu einem besseren Ergebnis und sie sind auf ultradünne Glasschichten angewendet worden, wie beispielsweise in WO 2012/067042 A1 und WO 2013/050166 A1.

Es sind auch laminierte Verbindungen einer ultradünnen Glasschicht mit einer polymeren Schicht bekannt, beispielsweise aus WO 2012/166343 A2. Solche Laminate eignen sich als vorgefertigte Ausgangsprodukte für die industrielle Massenproduktion in vielen Anwendungsbereichen. Wird die Glasschicht eines solchen Laminats mittels bekannter Laserverfahren geschnitten, so werden die Teile der Glasschicht weiterhin durch die polymere Schicht zusammengehalten. Es ist ein nachfolgender weiterer Schritt zur Durchtrennung der polymeren Schicht erforderlich, beispielsweise durch mechanisches Zerschneiden.

Weiterer Stand der Technik kann US 5622540 A und US 2014/0054348 A1 entnommen werden.

Die Aufgabe der vorliegenden Erfindung ist es, ein Verfahren zum Schneiden einer laminierten, ultradünnen Glasschicht bereitzustellen. Das Verfahren soll zu möglichst glatten Schnittkanten führen, ein geringes Risiko der Glasschädigung aufweisen und insbesondere die Möglichkeit bieten, das Laminat in einem Schritt zurechtzuschneiden.

Die Aufgabe der vorliegenden Erfindung wird erfindungsgemäß durch ein Verfahren zum Schneiden eines Laminats aus mindestens einer Glasschicht und mindestens einer polymeren Schicht gemäß dem unabhängigen Anspruch 1 gelöst. Bevorzugte Ausführungen gehen aus den Unteransprüchen hervor.

Durch die Verfahrensschritte (a), (b) und (c) wird die Glasschicht auf schonende Weise zerschnitten, so dass sich glatte Schnittkanten ohne störende Beschädigungen ausbilden. Die polymere Schicht wird entlang derselben Schnittlinie durch Bewegen eines zweiten Laserstrahls durchtrennt.

Das Durchtrennen der polymeren Schicht kann prinzipiell vor, zeitgleich mit oder nach dem Schneiden der Glasschicht erfolgen. In einer bevorzugten Ausführung erfolgt das Durchtrennen der polymeren Schicht in etwa zeitgleich mit dem Schneiden der Glasschicht, was für eine industrielle Fertigung höhere Taktzeiten ermöglicht und daher vorteilhaft ist. Dazu erfolgt die Bewegung des zweiten Laserstrahls bevorzugt zeitgleich (simultan) mit dem Bewegen des ersten Laserstrahls oder dem Bewegen des Mittels zum Kühlen, wenn eine solche Bewegung vorgesehen ist.

Die zeitliche Reihenfolge der Verfahrensschritte (b) und (c) ist nicht so zu verstehen, dass die Laserbestrahlung entlang der gesamten Schnittlinie abgeschlossen sein muss, bevor das Kühlen beginnt. Vielmehr kann, während sich der Laserstrahl noch über die Schnittlinie bewegt, bereits mit dem Kühlen der bereits vom Laserstrahl überstrichenen Bereiche der Schnittlinie begonnen werden. Bevorzugt wird ein Mittel (Vorrichtung) zum Kühlen in Bewegungsrichtung hinter dem Laserstrahl angeordnet und der Laserstrahl und das Mittel zum Kühlen mit der gleichen Geschwindigkeit entlang der Schnittlinie bewegt.

Diejenige Oberfläche der Glasschicht, die von der polymeren Schicht abgewandt ist, wird im Sinne der Erfindung als erste Oberfläche bezeichnet. Die erste Oberfläche wird erfindungsgemäß mit dem Kratzer versehen und die erste Oberfläche wird mit dem ersten Laserstrahl bestrahlt und gekühlt. Die Bestrahlung mit dem Laserstrahl erfolgt bevorzugt aus der der ersten Oberfläche zugewandten Richtung, so dass der Laserstrahl vor dem Auftreffen auf die erste Oberfläche das Laminat nicht durchdringen muss.

Die Glasschicht des Laminats ist insbesondere eine ultradünne Glasschicht. Unter einer ultradünnen Glasschicht wird im Sinne der Erfindung eine Glasschicht mit einer Dicke von kleiner oder gleich 0,3 mm verstanden. Die Dicke der Glasschicht beträgt bevorzugt von 0,03 mm bis 0,3 mm, besonders bevorzugt von 0,05 mm bis 0,15 mm.

Auf Glasschichten mit diesen Dicken ist das erfindungsgemäße Verfahren besonders gut anwendbar und führt zu geschnittenem Glas mit besonders glatten Kanten.

Der oberflächliche Kratzer (oder die oberflächliche Kerbe) führt zu einer Spannungskonzentration und bestimmt die Schnittlinie gleichsam als Sollbruchlinie. Die anschließende Bestrahlung der Schnittlinie mit einem Laserstrahl führt zu einer Erwärmung der Glasschicht entlang der Schnittlinie. Durch das darauffolgende Kühlen werden thermische Spannungen erzeugt, welche selbstständig zum Bruch der Glasschicht entlang der Schnittlinie führt. Eine zusätzliche mechanische Einwirkung (Brechen durch Druckausüben), wie es bei dickeren Glasscheiben notwendig ist, ist beim Schneiden des erfindungsgemäßen ultradünnen Glases nicht notwendig. Das Verfahren ist daher insbesondere für eine industrielle Massenfertigung sehr vorteilhaft. Zudem hat sich gezeigt, dass mit dem erfindungsgemäßen Verfahren eine Schädigung des Glases vermieden werden kann und glatte Schnittkanten erzeugt werden.

Der Kratzer wird erfindungsgemäß ausgehend von einer Seitenkante der Glasschicht erzeugt und erstreckt sich über eine gewisse Strecke entlang der gewünschten Schnittlinie. Die Länge des Kratzers beträgt bevorzugt von 0,5 mm bis 50 mm, besonders bevorzugt von 1 mm bis 20 mm, ganz besonders bevorzugt von 2 mm bis 10 mm. Die Tiefe des oberflächlichen Kratzers beträgt bevorzugt von 0.01 mm bis zur Hälfte der Glasdicke, besonders bevorzugt von 0.01 mm bis 0.05 mm.

In einer vorteilhaften Ausführung wird der Kratzer mechanisch mittels eines Schneidewerkzeugs erzeugt, insbesondere mit einem Diamantwerkzeug. Das Schneidewerkzeug ist bevorzugt mit einer Steuerung verbunden, über welche die Bewegung des Werkzeugs und der durch das Werkzeug ausgeübte Druck gesteuert und reguliert werden können.

In einer alternativen vorteilhaften Ausführung wird der oberflächliche Kratzer mittels Laserstrahlung erzeugt. Es hat sich gezeigt, dass ein gepulster Laser, insbesondere mit Pulsen im Pikosekundenbereich, mit einer Wellenlänge von 300 nm bis 1200 nm besonders geeignet ist, die oberflächlichen Glasschichten ohne unerwünschte Beschädigungen abzutragen. Besonders geeignet ist ein dotierter YAG-Laser, besonders bevorzugt ein Nd:YAG-Laser, der eine Wellenlänge von 1064 nm aufweist, aber auch frequenzverdoppelt (532 nm) oder frequenzverdreifacht (355 nm) betrieben werden kann. Die Pulslänge beträgt bevorzugt von 1 ps bis 20 ps, die Pulsfolgefrequenz beträgt bevorzugt von 100 kHz bis 800 kHz. Es hat sich gezeigt, dass ein solcher Laserstrahl zu besonders guten Kerben führt und das Risiko von unerwünschten Glasschädigungen verringert wird. Die Bewegungsgeschwindigkeit der Laserstrahlung über die Glasoberfläche beträgt bevorzugt von 1000 mm/s bis 5000 mm/s. Die Laserstrahlung wird bevorzugt mittels eines Scanners über die Glasoberfläche bewegt und mittels eines optischen Elements auf die Glasoberfläche fokussiert, bevorzugt mit einer f-Θ-Linse.

Es hat sich gezeigt, dass bei zu hohen Laserleistungen die Gefahr von Schädigungen der Glasschicht, welche später zum Bruch des Glases führen können, wächst. Die Leistung des Lasers beträgt bevorzugt von 0,5 W bis 3 W, besonders bevorzugt von 0,5 W bis 2 W, ganz besonders bevorzugt von 0,8 W bis 1,5 W. Leistungen in diesem Bereich sind ausreichend zur Erzeugung des Kratzers, schädigen die Glasoberfläche jedoch nicht.

Nach der Erzeugung des oberflächlichen Kratzer wird die Glasoberfläche entlang der gewünschten Schnittlinie mit einem ersten Laserstrahl bestrahlt. Der Laserstrahl wird dazu ausgehend von dem oberflächlichen Kratzer entlang der gesamten gewünschten Schnittlinie bewegt, in der Regel also bis zur gegenüberliegenden Seitenkante der Glasschicht.

Durch die Laserstrahlung wird die Glasschicht entlang der Schnittlinie erwärmt. Es eignet sich daher besonders Laserstrahlung mit einer Wellenlänge, für die die Glasschicht einen hohen Absorptionskoeffizienten aufweist. Besonders geeignet ist aus diesem Grund Laserstrahlung im mittleren Infrarotbereich. Die Laserstrahlung weist bevorzugt eine Wellenlänge von 1 µm bis 20 µm auf, besonders bevorzugt von 5 µm bis 15 µm. Besonders geeignet ist ein CO₂-Laser, typischerweise mit einer Wellenlänge von 9,4 µm oder 10,6 µm.

Der Laser wird bevorzugt im Dauerstrichbetrieb (CW, *continuous wave*) betrieben. Es hat sich gezeigt, dass damit eine gute Erwärmung der Glasschicht erreicht wird. Zudem ist ein Dauerstrichbetrieb technisch einfacher zu bewerkstelligen als ein gepulster Betrieb.

Die Laserstrahlung wird bevorzugt mittels eines optischen Elements oder Systems auf die Glasoberfläche fokussiert, wobei bevorzugt ein elongiertes, etwa ovales Strahlprofil erzeugt wird, beispielsweise mit einer Zylinderlinse. Die längere Achse des elongierten Strahlprofils ist dabei bevorzugt in Richtung der Schnittlinie ausgerichtet. Die Länge des Strahlprofils auf der Glasoberfläche beträgt bevorzugt von 10 mm bis 50 mm, die Breite beträgt bevorzugt von 100 µm bis 1 mm. Damit werden besonders gute Ergebnisse erzielt, insbesondere im Hinblick auf eine saubere Schnittkante. Die Brennweite des optischen Elements beträgt beispielsweise von 100 mm bis 200 mm. Damit werden gute Ergebnisse erzielt.

Die Laserstrahlung wird über die Glasoberfläche bewegt. Dies kann prinzipiell durch Bewegung der Glasschicht und/oder durch Bewegung der Laserstrahlung erfolgen. In einer vorteilhaften Ausführung wird die Laserstrahlung über die (insbesondere ortsfeste) Glasschicht bewegt. Hierfür eignen sich an sich bekannte Laser-Scan-Vorrichtungen, im einfachsten Fall ein oder mehrere kippbare Spiegel. Die Laserstrahlung kann auch beispielweise durch Bewegung eines Lichtwellenleiters, beispielsweise einer Glasfaser über die Glasoberfläche bewegt werden.

Die Laserstrahlung wird bevorzugt mit einer Geschwindigkeit von 1 m/min bis 30 m/min, besonders bevorzugt von 5 m/min bis 20 m/min über Glasoberfläche bewegt, ganz besonders bevorzugt von 10 m/min bis 15 m/min. Damit werden besonders gute Ergebnisse erzielt.

Die Leistung der Laserstrahlung (Ausgangsleistung) beträgt bevorzugt von 30 W bis 1 kW, beispielsweise von 50 W bis 100 W. Mit solchen Leistungen kann eine ausreichende Erwärmung der Glasschicht erreicht werden. Es können aber auch deutlich höhere Leistungen verwendet werden.

Die Glasoberfläche wird nach dem Erwärmen abgekühlt. Durch die aufeinanderfolgende Erwärmung und Abkühlung werden entlang der Schnittlinie thermische Spannungen erzeugt, die bei der ultradünnen Glasschicht selbstständig zum erwünschten Bruch führen. Das Kühlen erfolgt bevorzugt durch Beaufschlagen der Glasoberfläche mit einem gasförmigen und/oder flüssigen Kühlmittel entlang der Schnittlinie. Die Erfindung ist nicht auf bestimmte Kühlmittel beschränkt. Bevorzugte Kühlmittel sind Luft und/oder Wasser, weil eine solche Kühlung einfach zu realisieren und kostengünstig ist. Besonders bevorzugt wird ein Luft/Wasser-Gemisch als Kühlmittel verwendet.

Das Kühlmittel wird bevorzugt mittels einer Düse entlang der Schnittlinie auf die Glasoberfläche gebracht. Die Düse wird bevorzugt mit der gleichen Geschwindigkeit hinter der Laserstrahlung über die Glasoberfläche bewegt. Der Zeitunterschied zwischen dem Erwärmen der Glasschicht mittels Laserstrahlung und dem Abkühlen ("Abschrecken") der Glasschicht beträgt bevorzugt von 10 ms bis 500 ms, besonders bevorzugt von 50 ms bis 100 ms. Damit werden besonders geeignete thermische Spannungen erzeugt, die zu einem effektiven Bruch mit sauberen Bruchkanten führen.

Die polymere Schicht des erfindungsgemäßen Laminats enthält bevorzugt ein thermoplastisches Polymer, besonders bevorzugt zumindest Ethylen-Tetrafluorethylen (ETFE), Polyethylenterephthalat (PET), Ethylenvinylacetat (EVA), Polyurethan (PU) und / oder Polyvinylbutyral (PVB). Die polymere Schicht kann aber auch beispielsweise Polypropylen, Polycarbonat, Polymethylmetacrylat, Polyacrylat, Polyvinylchlorid, Polyacetatharz, Acrylate, Fluorinierte Ethylen-Propylene, Polyvinylfluorid und/oder enthalten.

Die polymere Schicht weist bevorzugt eine Dicke im Bereich der Dicke der Glasschicht auf. Die Dicke der polymeren Schicht beträgt bevorzugt von 0,03 mm bis 0,3 mm, besonders bevorzugt von 0,05 mm bis 0,15 mm. Es können grundsätzlich aber auch dickere polymere Schichten verarbeitet werden.

In einer besonders vorteilhaften Ausführung umfasst das Laminat genau eine Glasschicht und mindestens eine polymeren Schicht. Umfasst das Laminat mehr als eine einzelne polymere Schicht, so sind alle polymeren Schichten bevorzugt als Schichtenstapel auf einer Seite der Glasschicht angeordnet, so dass eine Oberfläche der Glasschicht (im Sinne der Erfindung die erste Oberfläche) nicht mit einer polymeren Schicht verbunden ist, sondern frei liegt. Die von der polymeren Schicht abgewandte (erste) Oberfläche der Glasschicht wird mit dem oberflächlichen Kratzer versehen, mit dem ersten Laserstrahl erwärmt und anschließend abgekühlt. Die polymere Schicht wird mit dem zweiten Laserstrahl bestrahlt. Die Bestrahlung mit dem zweiten Laserstrahl zur Durchtrennung der polymeren Schicht kann aus der gleichen Richtung wie die Bestrahlung mit dem ersten Laserstrahl erfolgen. In diesem Falle muss der zweite Laserstrahl durch die Glasschicht hindurch transmittiert werden, weshalb für den zweiten Laserstrahl eine Wellenlänge zu verwenden ist, die von der Glasschicht möglichst wenig absorbiert wird. Es eignet sich insbesondere Laserstrahlung im sichtbaren Spektralbereich.

In einer bevorzugten Ausführung des Verfahrens wird die polymere Schicht aus der der Glasschicht gegenüberliegenden Richtung bestrahlt. Die Laserstrahlung muss dann die Glasschicht nicht durchdringen und die Wellenlänge der Laserstrahlung muss sich nicht nach dem Absorptionsverhalten der Glasschicht richten. Ein besonderer Vorteil ist es dabei, dass für den ersten und den zweiten Laserstrahl dieselbe Wellenlänge verwendet werden kann. In einer besonders bevorzugten Ausführung werden der erste Laserstrahl zum Schneiden der Glasschicht und der zweite Laserstrahl zum Trennen der polymeren Schicht durch denselben Laser erzeugt. Die Strahlung des Lasers wird durch geeignete optische Elemente in zwei Teilstrahlen aufgeteilt, die so geleitet werden, dass sie von entgegengesetzten Seiten auf das Laminat treffen. Der erste Laserstrahl und der zweite Laserstrahl bestrahlen das Laminat aus entgegengesetzten Richtungen. Der Vorteil liegt in einem einfacheren technischen Aufbau mit nur einer Laserquelle. In einer bevorzugten Ausführung werden erste Laserstrahlung und zweite Laserstrahlung simultan bewegt.

In einer weiteren besonders vorteilhaften Ausführung umfasst das Laminat zwei Glasschichten. Die erste Glasschicht ist über die mindestens eine polymere Schicht mit einer zweiten Glasschicht verbunden. Das Glasschneideverfahren mit der Erzeugung des oberflächlichen Kratzers, der Laserbestrahlung und Abkühlung wird auf den von der thermoplastischen Schicht abgewandten, äußeren (ersten) Oberflächen der beiden Glasschichten entlang einer gemeinsamen Schnittlinie durchgeführt. Das Schneiden der ersten und zweiten Glasschicht kann zeitlich nacheinander, zeitlich versetzt oder simultan erfolgen, bevorzugt simultan. Die dazu benötigte Laserstrahlung kann durch denselben Laser erzeugt werden.

Die zweite Glasschicht weist bevorzugt eine Dicke im Bereich der Dicke der ersten Glasschicht auf. Die Dicke der zweiten Glasschicht beträgt bevorzugt von 0,03 mm bis 0,3 mm, besonders bevorzugt von 0,05 mm bis 0,15 mm.

Das Laminat kann neben den Glasschichten und der polymeren Schicht weitere Schichten umfassen. Beispielsweise kann das Laminat eine Dünnschichtsolarzelle sein oder ein aktives Verglasungselement mit schaltbaren, insbesondere elektrisch schaltbaren Eigenschaften. Solche Verglasungen enthalten aktive Schichten und Elektrodenschichten zur elektrischen Kontaktierung. Das Laminat kann beispielsweise ein elektrochromes Element, ein PDLC-Element (Polymer dispersed liquid crystal), ein elektrolumineszentes Element, eine organische Leuchtdiode (OLED) oder ein SPD-Element (suspended particle device) sein. Die Funktionsweise solche Verglasungselemente ist dem Fachmann hinlänglich bekannt, beispielsweise aus WO 2012007334 A1, US 20120026573 A1, WO 2010147494 A1 und EP 1862849 A1 (elektrochrom), DE 102008026339 A1 (PDLC), US 2004227462 A1 und WO 2010112789 A2 (OLED), EP 0876608 B1 und WO 2011033313 A1 (SPD). Durch das erfindungsgemäße Laminat mit den ultradünnen Glasschichten weist das Verglasungselement eine folienartige Flexibilität und Verarbeitbarkeit auf. Mit solchen Verglasungselementen können beispielsweise herkömmliche Fensterglaser einfach nachträglich mit aktiven, schaltbaren Funktionen nachgerüstet werden.

Die polymere Schicht wird mittels Laserstrahlung durch die ersten Glasschicht oder die zweiten Glasschicht hindurch bestrahlt wird. Dadurch wird die thermoplastische Schicht entlang der Schnittlinie durchtrennt. Da die Laserstrahlung durch eine Glasschicht hindurch transmittiert werden muss, ist für die Laserstrahlung eine Wellenlänge zu verwenden ist, die von der Glasschicht möglichst wenig absorbiert wird. Es eignet sich insbesondere Laserstrahlung im sichtbaren Spektralbereich, Nahinfrarotbereich oder Nah-UV-Bereich. Die Wellenlänge beträgt bevorzugt von 300 nm bis 1200 nm. In einer bevorzugten Ausführung wird ein dotierter YAG-Laser, besonders bevorzugt ein Nd:YAG-Laser, der eine Wellenlänge von 1064 nm aufweist, aber auch frequenzverdoppelt (532 nm) oder frequenzverdreifacht (355 nm) betrieben werden kann. Das Durchtrennen der thermoplastischen Schicht erfolgt in einer bevorzugten Ausführung simultan mit dem Schneiden der Glasschichten. Es ist aber auch ein zeitliches Aufeinanderfolgen verschiedener Schneideschritte möglich.

Die Laserstrahlung zum Durchtrennen der polymeren Schicht ist bevorzugt gepulst, besonders bevorzugt mit Pulsen im Pikosekundenbereich. Die Pulslänge beträgt bevorzugt von 1 ps bis 10 ps, die Pulsfolgefrequenz beträgt bevorzugt von 200k Hz bis 800k Hz. Die Leistung beträgt bevorzugt von 5 W bis 50 W. Die Laserstrahlung wird bevorzugt mittels eines Scanners und mittels eines optischen Elements auf die thermoplastische Schicht fokussiert, bevorzugt mit einer f-Θ-Linse.

Ein Vorteil des erfindungsgemäßen Verfahrens zum Schneiden ultradünner Glaslaminate ist, dass es einfach in eine industrielle Massenfertigung integriert werden kann, bei der ultradünne Glasschichten typischerweise im Ausgangszustand auf eine Rolle aufgerollt sind. Daher wird in einer vorteilhaften Ausführung das Glaslaminat unmittelbar vor dem Schneiden von einer Rolle abgerollt.

Die Glasschicht oder Glasschichten sind nicht auf eine bestimmte Glassorte beschränkt. Vielmehr ist das erfindungsgemäße Verfahren grundsätzlich auf ultradünne Glasschichten beliebiger Zusammensetzung anwendbar. Die Glasschicht oder Glasschichten enthalten beispielsweise Kalk-Natron-Glas oder Borosilikatglas.

Die Erfindung umfasst weiter eine Vorrichtung gemäß Anspruch 13.

Die vorstehend im Zusammenhang mit dem erfindungsgemäßen Verfahren ausgeführten vorteilhaften Ausgestaltungen gelten in gleicher Weise für die Vorrichtung.

Die Vorrichtung umfasst in einer vorteilhaften Ausgestaltung weiter eine Rollenhalterung, in welche eine mit dem ultradünnen Glaslaminat versehene Rolle eingesetzt werden kann. Die Rollenhalterung ist dabei so angeordnet, dass das von der Rolle abgerollte Glaslaminat mit dem Mittel zum Erzeugen des Kratzers, der Laserstrahlung und dem Mittel zum Kühlen bearbeitet werden kann.

Gezeigt ist auch die Verwendung eines erfindungsgemäß geschnittenen ultradünnen Glaslaminats in einer oder als Dünnschichtsolarzelle oder aktiven Verglasung mit schaltbaren, insbesondere elektrisch schaltbaren Eigenschaften, bevorzugt einem elektrochromen Element, PDLC-Element (Polymer dispersed liquid crystal), elektrolumineszenten Element, einer organischen Leuchtdiode (OLEDs) oder SPD-Element (suspended particle device).

Die Erfindung wird anhand von Figuren und Ausführungsbeispielen näher erläutert. Die Figuren sind schematische Darstellungen und nicht maßstabsgetreu. Die Figuren schränken die Erfindung in keiner Weise ein. Es zeigen:
- Fig. 1: eine perspektivische Ansicht eines ultradünnen Glaslaminats während des erfindungsgemäßen Verfahrens,
- Fig. 2: einen Querschnitt durch das Laminat entlang der Schnittlinie L,
- Fig. 3: einen Querschnitt durch eine weitere Ausgestaltung des Laminats und
- Fig. 4: ein Ausführungsbeispiel des erfindungsgemäßen Verfahrens anhand eines Flussdiagramms.

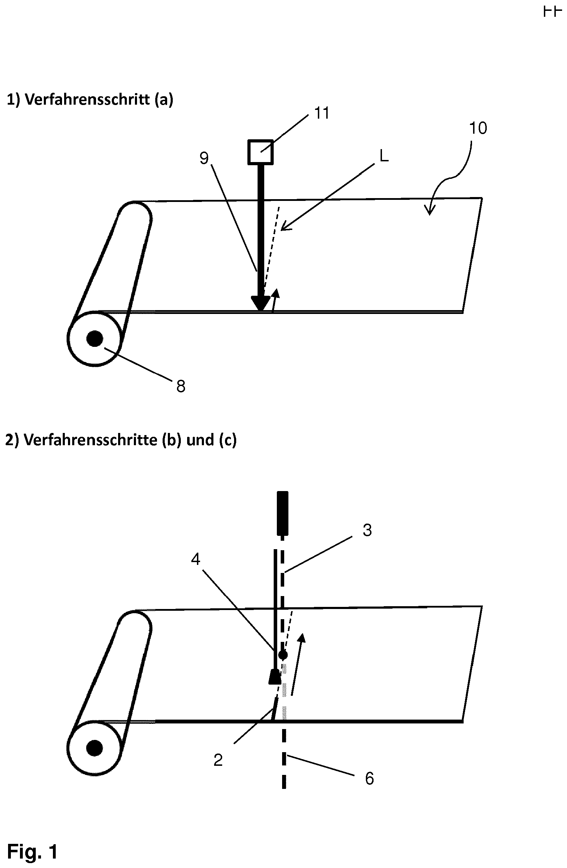

Fig. 1 zeigt eine schematische Darstellung des erfindungsgemäßen Verfahrens. Ein Laminat 10 mit einer ultradünnen Glasschicht und einer polymeren Schicht ist auf einer Rolle 8 bereitgestellt und teilweise von der Rolle 8 abgerollt worden. Das erfindungsgemäße Verfahren wird angewandt, um mittels eines Schnitts senkrecht zur Abrollrichtung einen Teil des Laminats 10 abzutrennen.

Im ersten Verfahrensschritt wird mit einem Mittel 9 ein oberflächlicher Kratzer 2 in die erste, von der polymeren Schicht abgewandte Oberfläche der Glasschicht eingebracht. Das Mittel 9 zum Einbringen des Kratzers 2 ist beispielsweise ein Diamantwerkzeug, wobei die Bewegung und der ausgeübte Druck durch eine Steuerung 11 geregelt werden können.

Alternativ kann das Mittel 9 auch beispielsweise ein Nd:YAG-Laser mit Pulsen im Pikosekundenbereich (beispielsweise Pulslänge von 10 ps und Pulsfolgefrequenz von 400k Hz) und einer Leistung von 1W sein. Der Kratzer 2 weist beispielsweise eine Tiefe von 0,03 mm und eine Länge von 5 mm auf und erstreckt sich ausgehend von einer Seitenkante der Glasschicht 1 entlang der gewünschten Schnittlinie L. Der Kratzer 2 führt zu einer Spannungskonzentration und definiert die gewünschte Schnittlinie L, entlang der er sich über seine Länge von 5 mm erstreckt, als Sollbruchstelle.

Anschließend wird ein erster Laserstrahl 3 ausgehend vom Kratzer 2 entlang der Schnittlinie L bewegt. Der Laserstrahl 3 ist der Strahl eines CO₂-Lasers im Dauerstrichbetrieb mit einer Wellenlänge von 10,6 µm und einer Leistung von 50 W. Der Laserstrahl 3 ist mittels einer nicht dargestellten Zylinderoptik mit elongiertem Strahlprofil auf die Glasoberfläche fokussiert. Auf der Glasoberfläche weist das Profil beispielsweise eine Länge von 30 mm und eine Breite von 500 µm auf. Das Strahlprofil ist entlang der Schnittlinie L ausgerichtet, die lange Achse des Strahlprofils liegt also auf der Schnittlinie L. Der Laserstrahl 3 wird effektiv durch die Glasschicht 1 absorbiert, wodurch die Glasschicht entlang der Schnittlinie L erwärmt wird.

Hinter dem Laserstrahl 3 wird eine Düse 4 entlang der Schnittlinie L bewegt. Laserstrahl 3 und Düse 4 bewegen sich dabei mit der gleichen Geschwindigkeit. Die Glasschicht wird mittels der Düse 4 mit einem Kühlmittel beaufschlagt, beispielsweise einem Luft/WasserGemisch. Das schnelle Abkühlen der erwärmten Glasschicht führt zu thermischen Spannungen, welche zum Bruch der Glasschicht 1 entlang der Schnittlinie L führen.

Die in der Figur dargestellten Pfeile deuten die Bewegungsrichtung an.

Ein zweiter Laserstrahl 6 ist aus der gegenüberliegenden Richtung auf die thermoplastische Schicht 5 fokussiert. Der zweite Laserstrahl 6 wird mit der gleichen Geschwindigkeit v bewegt wie der erste Laserstrahl 3 und die Düse 4. Der zweite und der erste Laserstrahl (3, 6) bewegen sich insbesondere simultan, so dass sich die Laserfoki in etwa auf der gleichen Position auf der Schnittlinie L befinden. Der Laserstrahl 6 durchtrennt die thermoplastische Schicht 5. In einer bevorzugten Ausführung werden die Laserstrahlen 3 und 6 durch denselben Laser erzeugt. Es kann aber auch für beide Strahlen 3, 6 ein eigener Laser vorgesehen sein.

Wie sich gezeigt hat, erfolgt der Bruch der ultradünnen Glasschicht selbstständig aufgrund der thermischen Spannungen. Auf ein aktives Brechen durch Ausüben von Druck kann daher verzichtet werden. Das erfindungsgemäße Verfahren eignet sich daher für die industrielle Massenproduktion, wo die Glasschicht typischerweise von einer Rolle 8 abgerollt und direkt verarbeitet wird. Zudem führt das Verfahren zu glatten Schnittkanten ohne störende Beschädigungen wie Mikrorisse. Das Laminat 10 mit der Glasschicht und der thermoplastischen Schicht kann durch das erfindungsgemäße Verfahren in einem Schritt getrennt werden, was fertigungstechnisch sehr vorteilhaft ist.

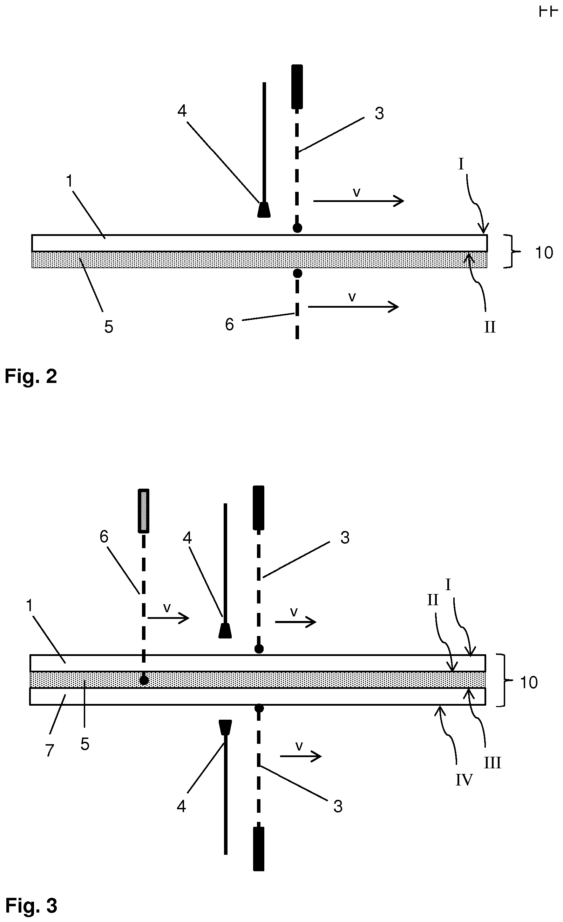

Fig. 2 zeigt einen Querschnitt durch das Laminat 10 während des Verfahrens gemäß Figur 1. Das Laminat 10 umfasst die Glasschicht 1, deren zweite Oberfläche II mit der polymeren, thermoplastischen Schicht 5 verbunden ist. Die von der polymeren Schicht 5 abgewandte Oberfläche der Glasschicht 1, auf welcher das Erzeugen des Kratzers, das Bestrahlen mit dem ersten Laserstrahl 3 und das Beaufschlagen mit dem Kühlmittel erfolgt, wird im Sinne der Erfindung als erste Oberfläche I bezeichnet. Die Glasschicht 1 weist eine Dicke von beispielsweise 100 µm auf. Die thermoplastische Schicht 5 besteht beispielsweise aus einer 100 µm dicken Folie aus ETFE.

Der Laserstrahl 3 und die Düse 4 werden mit der Geschwindigkeit v hintereinander entlang der Schnittlinie L bewegt. Der zweite Laserstrahl 6 wird mit derselben Geschwindigkeit v simultan bewegt.

Fig. 3 zeigt einen Querschnitt durch ein weiteres Laminat. Dabei ist eine erste Glasschicht 1 mit einer zweiten Glasschicht 7 über eine polymere Schicht 5 verbunden. Die zur polymeren Schicht 5 hingewandten Oberflächen II, III der Glasschichten 1, 7 werden im Sinne der Erfindung als zweite Oberflächen bezeichnet. Die von der polymeren Schicht 5 abgewandten Oberflächen I, IV werden als erste Oberflächen bezeichnet. Die polymere Schicht 5 ist wieder beispielsweise eine thermoplastische Folie aus ETFE mit einer Dicke von 100 µm.

Das erfindungsgemäße Glasschneideverfahren mit dem oberflächlichen Kratzer 2, dem Laserstrahl 3 und der Düse 4 wird simultan auf den ersten Oberflächen I, IV der Glasschichten 1, 7 ausgeführt, wodurch die Glasschichten entlang einer gemeinsamen Schnittlinie L durchtrennt werden. Ein Laserstrahl 6 ist durch die erste Glasschicht 1 hindurch auf die thermoplastische Schicht 5 fokussiert und wird mit der gleichen Geschwindigkeit v wie die anderen Laserstrahlen 3 und die Düse 4 entlang der Schnittlinie L bewegt. Der Laserstrahl 6 weist beispielsweise eine Wellenlänge von 532 nm auf und wird durch einen frequenzverdoppelten Nd:YAG-Laser erzeugt. Licht im sichtbaren Bereich wird durch die Glasschicht 1 nicht wesentlich absorbiert, so dass der Laserstrahl 6 weitgehend ungehindert auf die thermoplastische Schicht 5 trifft. Der Nd:YAG-Laser wird beispielsweise mit Pulsen im Pikosekunden-Bereich betrieben (beispielsweise Pulslänge von 10 ps und Pulsfolgefrequenz von 400k Hz) und weist eine Leistung von 1W auf.

In der schematischen Darstellung ist der zweite Laserstrahl 6 in Bewegungsrichtung hinter den beiden ersten Laserstrahlen 3 und den Düsen 4 angeordnet. So erfolgt zunächst das Schneiden der Glasschichten 1, 7 und zeitlich versetzt das Durchtrennen des Laminats. Der zweite Laserstrahl 6 kann aber auch auf die Position auf der Schnittlinie L gerichtet sein, auf der sich die ersten Laserstrahlen 3, 6 befinden. Dann erfolgt das Schneiden der Glasschichten 1, 7 und das Durchtrennen der polymeren Schicht 5 simultan.

Das Laminat mit den Glasschichten 1, 7 und der thermoplastischen Schicht 5 kann durch das erfindungsgemäße Verfahren in einem Schritt getrennt werden, was fertigungstechnisch sehr vorteilhaft ist.

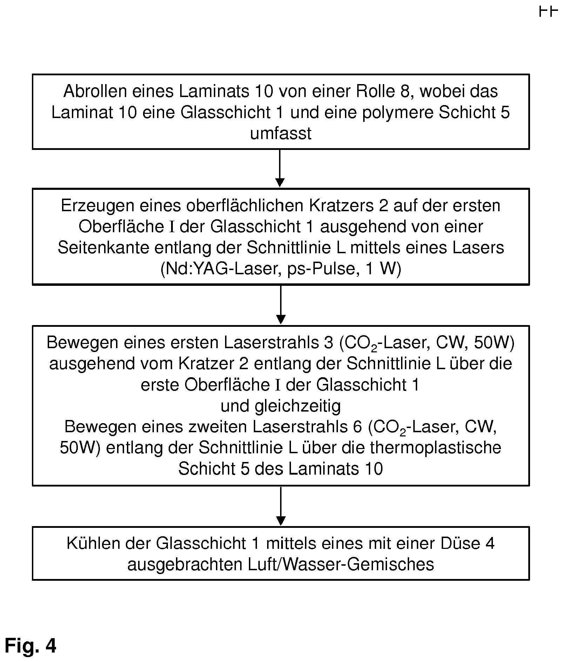

Fig. 4 zeigt ein Ausführungsbeispiel des erfindungsgemäßen Verfahrens zum Schneiden laminierter, ultradünner Glasschichten.

### Bezugszeichenliste:

- (10): Laminat

- (1): (erste) Glasschicht
- (2): oberflächlicher Kratzer
- (3): Laserstrahlung zum Schneiden der Glasschicht 1
- (4): Düse zum Kühlen der Glasschicht 1
- (5): polymere Schicht
- (6): Laserstrahlung zum Durchtrennen der polymeren Schicht 5
- (7): zweite Glasschicht
- (8): Rolle
- (9): Mittel zum Erzeugen des oberflächlichen Kratzer 2
- (11): Steuerung des Mittels 9

- L: Schnittlinie

- I: erste Oberfläche der Glasschicht 1
- II: zweite Oberfläche der Glasschicht 1
- III: erste Oberfläche der zweiten Glasschicht 7
- IV: zweite Oberfläche der zweiten Glasschicht 7

## Patentansprüche

1. Verfahren zum Schneiden eines Laminats (10) aus mindestens einer Glasschicht (1) mit einer Dicke von kleiner oder gleich 0,3 mm und mindestens einer polymeren Schicht (5), mindestens umfassend:
a) Erzeugen eines oberflächlichen Kratzers (2) auf einer ersten Oberfläche (I) der Glasschicht (1), wobei sich der Kratzer (2) ausgehend von einer Seitenkante entlang einer Schnittlinie (L) erstreckt;
b) anschließend Bewegen eines ersten Laserstrahls (3) ausgehend vom Kratzer (2) über die erste Oberfläche (I) entlang der Schnittlinie (L);
c) anschließend Kühlen der Glasschicht (1) entlang der Schnittlinie (L), wobei die Glasschicht (1) entlang der Schnittlinie (L) bricht;
und wobei die polymere Schicht (5) durch Bewegen eines zweiten Laserstrahls (6) entlang der Schnittlinie (L) durchtrennt wird.

2. Verfahren nach Anspruch 1, wobei der erste Laserstrahl (3) eine Wellenlänge von 1 µm bis 20 µm aufweist, bevorzugt von 5 µm bis 15 µm.

3. Verfahren nach Anspruch 1 oder 2, wobei der erste Laserstrahl (3) durch einen CO₂-Laser erzeugt wird, bevorzugt im Dauerstrichbetrieb.

4. Verfahren nach einem der Ansprüche 1 bis 3, wobei der erste Laserstrahl (3) und der zweite Laserstrahl (6) durch denselben Laser erzeugt werden und das Laminat (10) aus entgegengesetzten Richtungen bestrahlen.

5. Verfahren nach einem der Ansprüche 1 bis 4, wobei die Glasschicht (1) über die polymere Schicht (5) mit einer zweiten Glasschicht (7) verbunden ist und
wobei die Verfahrensschritte (a), (b) und (c) auf die von der polymeren Schicht (5) abgewandten Oberflächen (I, IV) der Glasschichten (1, 7) angewandt werden und
wobei die polymere Schicht (5) durch eine der Glasschichten (1,7) hindurch mit dem zweiten Laserstrahl (6) bestrahlt wird und wobei der zweite Laserstrahl (6) eine Wellenlänge von 300 nm bis 1200 nm aufweist.

6. Verfahren nach Anspruch 5, wobei der zweite Laserstrahl (6) durch einen dotierten YAG-Laser, bevorzugt einen Nd:YAG-Laser erzeugt wird, der besonders bevorzugt mit Pulsen im Pikosekundenbereich betrieben wird.

7. Verfahren nach einem der Ansprüche 1 bis 6, wobei der Kratzer (2) eine Länge von 0,5 mm bis 50 mm aufweist, bevorzugt von 1 mm bis 20 mm, besonders bevorzugt von 2 mm bis 10 mm.

8. Verfahren nach einem der Ansprüche 1 bis 7, wobei der Kratzer (2) mechanisch erzeugt wird.

9. Verfahren nach einem der Ansprüche 1 bis 7, wobei der Kratzer (2) mittels Laserstrahlung erzeugt wird, welche bevorzugt eine Wellenlänge von 300 nm bis 1200 nm aufweist und eine Leistung von 0,5 W bis 3 W.

10. Verfahren nach einem der Ansprüche 1 bis 9, wobei die erste Laserstrahl (3) mit einer Geschwindigkeit von 1 m/min bis 30 m/min, bevorzugt von 5 m/min bis 20 m/min über die erste Oberfläche (I) bewegt wird und wobei bevorzugt alle Laserstrahlen (3, 6) mit der gleichen Geschwindigkeit bewegt werden.

11. Verfahren nach einem der Ansprüche 1 bis 10, wobei das Kühlen der Glasschicht (1) durch Beaufschlagen mit einem gasförmigen und/oder flüssigen Kühlmittel, bevorzugt einem Luft/Wasser-Gemisch, entlang der Schnittlinie (L) erfolgt, bevorzugt mittels einer Düse (4).

12. Verfahren nach einem der Ansprüche 1 bis 11, wobei das Laminat (10) unmittelbar vor dem Schneiden von einer Rolle (8) abgerollt wird.

13. Vorrichtung zum Schneiden eines Laminats (10) aus mindestens einer Glasschicht (1) mit einer Dicke von kleiner oder gleich 0,3 mm und mindestens einer polymeren Schicht (5), mindestens umfassend:
- ein Mittel zum Erzeugen eines oberflächlichen Kratzers (2) auf einer ersten Oberfläche (I) der Glasschicht (1),
- ein Mittel zum Erzeugen und Bewegen eines ersten Laserstrahls (3), der dafür vorgesehen ist, ausgehend vom Kratzer (2) über die erste Oberfläche (I) entlang der Schnittlinie (L) bewegt zu werden,
- ein Mittel zum Kühlen der Glasschicht (1) entlang der Schnittlinie (L) und
- ein Mittel zum Erzeugen und Bewegen eines zweiten Laserstrahls (6), der dafür vorgesehen ist, die polymere Schicht (5) entlang der Schnittlinie (L) zu durchtrennen, wobei der erste Laserstrahl (3) und der zweite Laserstrahl (6) das Laminat (10) aus entgegengesetzten Richtungen bestrahlen.

14. Vorrichtung nach Anspruch 13, welche außerdem eine Rollenhalterung enthält, in welche eine mit dem Laminat (10) versehene Rolle (8) eingesetzt werden kann.

## Claims

1. Method for cutting a laminate (10) composed of at least one glass layer (1) with a thickness less than or equal to 0.3 mm and at least one polymeric layer (5), comprising at least:
a) generating a surface scratch (2) on a first surface (I) of the glass layer (1), wherein the scratch (2), starting from a lateral edge, extends along a cutting line (L);
b) subsequently moving a first laser beam (3), starting from the scratch (2), across the first surface (I) along the cutting line (L);
c) subsequently cooling the glass layer (1) along the cutting line (L), wherein the glass layer (1) breaks along the cutting line (L);
and wherein the polymeric layer (5) is severed by moving a second laser beam (6) along the cutting line (L).

2. Method according to claim 1, wherein the first laser beam (3) has a wavelength of 1 µm to 20 µm, preferably of 5 µm to 15 µm.

3. Method according to claim 1 or 2, wherein the first laser beam (3) is generated by a CO₂ laser, preferably in continuous wave operation.

4. Method according to one of claims 1 through 3, wherein the first laser beam (3) and the second laser beam (6) are generated by the same laser and irradiate the laminate (10) from opposite directions.

5. Method according to one of claims 1 through 4, wherein the glass layer (1) is bonded to a second glass layer (7) via the polymeric layer (5), and
wherein the process steps (a), (b), and (c) are applied on the surfaces (I, IV) of the glass layers (1, 7) facing away from the polymeric layer (5), and
wherein the polymeric layer (5) is irradiated with the second laser beam (6) through one of the glass layers (1,7), and
wherein the second laser beam (6) has a wavelength of 300 nm to 1200 nm.

6. Method according to claim 5, wherein the second laser beam (6) is generated by a doped YAG laser, preferably an Nd:YAG laser, which is particularly preferably operated with pulses in the picosecond range.

7. Method according to one of claims 1 through 6, wherein the scratch (2) has a length of 0.5 mm to 50 mm, preferably of 1 mm to 20 mm, particularly preferably of 2 mm to 10 mm.

8. Method according to one of claims 1 through 7, wherein the scratch (2) is mechanically generated.

9. Method according to one of claims 1 through 7, wherein the scratch (2) is generated by means of laser radiation, which preferably has a wavelength of 300 nm to 1200 nm and power of 0.5 W to 3 W.

10. Method according to one of claims 1 through 9, wherein the first laser beam (3) is moved at a speed of 1 m/min to 30 m/min, preferably of 5 m/min to 20 m/min across the first surface (I), and wherein, preferably, all laser beams (3, 6) are moved at the same speed.

11. Method according to one of claims 1 through 10, wherein the cooling of the glass layer (1) is done by impingement with a gaseous and/or liquid coolant, preferably an air/water mixture, along the cutting line (L), preferably by means of a nozzle (4).

12. Method according to one of claims 1 through 11, wherein the laminate (10) is unrolled from a roll (8) immediately before cutting.

13. Device for cutting a laminate (10) composed of at least one glass layer (1) with a thickness less than or equal to 0.3 mm and at least one polymeric layer (5), comprising at least:
- a means for generating a surface scratch (2) on a first surface (I) of the glass layer (1),
- a means for generating and moving a first laser beam (3), which is intended to be moved, starting from the scratch (2), along the cutting line (L) across the first surface (I),
- a means for cooling the glass layer (1) along the cutting line (L), and
- a means for generating and moving a second laser beam (6), which is intended to sever the polymeric layer (5) along the cutting line (L), wherein the first laser beam (3) and the second laser beam (6) irradiate the laminate (10) from opposite directions.

14. Device according to claim 13, which, furthermore, includes a roll holder, into which a roll (8) provided with the laminate (10) can be inserted.

## Revendications

1. Procédé de découpe d'un stratifié (10) composé d'au moins une couche de verre (1) d'une épaisseur inférieure ou égale à 0,3 mm et d'au moins une couche polymère (5), comprenant au moins :
a) générer une rayure de surface (2) sur une première surface (I) de la couche de verre (1), dans laquelle la rayure (2), en partant d'un bord latéral, s'étend le long d'une ligne de coupe (L);
b) déplacer ensuite un premier faisceau laser (3), en partant de la rayure (2), sur la première surface (I) le long de la ligne de coupe (L);
c) refroidir ensuite la couche de verre (1) le long de la ligne de coupe (L), la couche de verre (1) se brisant le long de la ligne de coupe (L);
et dans lequel la couche polymère (5) est rompue en déplaçant un second faisceau laser (6) le long de la ligne de coupe (L).

2. Procédé selon la revendication 1, dans lequel le premier faisceau laser (3) a une longueur d'onde de 1 µm à 20 µm, de préférence de 5 µm à 15 µm.

3. Procédé selon la revendication 1 ou 2, dans lequel le premier faisceau laser (3) est généré par un laser CO₂, de préférence en mode continu.

4. Procédé selon l'une des revendications 1 à 3, dans lequel le premier faisceau laser (3) et le second faisceau laser (6) sont générés par le même laser et irradient le stratifié (10) depuis des directions opposées.

5. Procédé selon l'une des revendications 1 à 4, dans lequel la couche de verre (1) est liée à une deuxième couche de verre (7) via la couche polymère (5), et
dans lequel les étapes de procédé (a), (b) et (c) sont appliquées sur les surfaces (I, IV) des couches de verre (1, 7) opposées à la couche polymère (5), et
dans lequel la couche polymère (5) est irradiée par le second faisceau laser (6) à travers l'une des couches de verre (1, 7), et
dans lequel le second faisceau laser (6) a une longueur d'onde de 300 nm à 1200 nm.

6. Procédé selon la revendication 5, dans lequel le second faisceau laser (6) est généré par un laser YAG dopé, de préférence un laser Nd:YAG, qui fonctionne de manière particulièrement préférée avec des impulsions dans la gamme des picosecondes.

7. Procédé selon l'une des revendications 1 à 6, dans lequel la rayure (2) présente une longueur de 0,5 mm à 50 mm, de préférence de 1 mm à 20 mm, de manière particulièrement préférée de 2 mm à 10 mm.

8. Procédé selon l'une des revendications 1 à 7, dans lequel la rayure (2) est générée mécaniquement.

9. Procédé selon l'une des revendications 1 à 7, dans lequel la rayure (2) est générée au moyen d'un rayonnement laser, qui présente de préférence une longueur d'onde de 300 nm à 1200 nm et une puissance de 0,5 W à 3 W.

10. Procédé selon l'une des revendications 1 à 9, dans lequel le premier faisceau laser (3) est déplacé à une vitesse de 1 m/min à 30 m/min, de préférence de 5 m/min à 20 m/min sur la première surface (I), et dans lequel, de préférence, tous les faisceaux laser (3, 6) sont déplacés à la même vitesse.

11. Procédé selon l'une des revendications 1 à 10, dans lequel le refroidissement de la couche de verre (1) se fait par impact avec un agent de refroidissement gazeux et/ou liquide, de préférence un mélange air/eau, le long de la ligne de coupe (L), de préférence au moyen d'une buse (4).

12. Procédé selon l'une des revendications 1 à 11, dans lequel le stratifié (10) est déroulé d'un rouleau (8) immédiatement avant la découpe.

13. Dispositif de découpe d'un stratifié (10) composé d'au moins une couche de verre (1) d'une épaisseur inférieure ou égale à 0,3 mm et d'au moins une couche polymérique (5), comprenant au moins :
- un moyen pour générer une rayure de surface (2) sur une première surface (I) de la couche de verre (1),
- un moyen pour générer et déplacer un premier faisceau laser (3), qui est destiné à être déplacé, en partant de la rayure (2), le long de la ligne de coupe (L) sur la première surface (I),
- un moyen pour refroidir la couche de verre (1) le long de la ligne de coupe (L), et
- un moyen pour générer et déplacer un second faisceau laser (6), qui est destiné à sectionner la couche polymère (5) le long de la ligne de coupe (L), dans lequel le premier faisceau laser (3) et le second faisceau laser (6) irradient le stratifié (10) depuis des directions opposées.

14. Dispositif selon la revendication 13, qui comprend en outre un support de rouleau, dans lequel un rouleau (8) muni du stratifié (10) peut être inséré.
